Europäisches Patentamt

European Patent Office

Office européen des brevets

(11) Publication number: **0 092 782**
**B1**

(12) **EUROPEAN PATENT SPECIFICATION**

(45) Date of publication of patent specification: **27.07.88**    (51) Int. Cl.⁴: **G 03 F 7/02**

(21) Application number: **83103824.5**

(22) Date of filing: **20.04.83**

(54) **Overcoated photohardenable element having surface protuberances.**

(30) Priority: **22.04.82 US 370993**

(43) Date of publication of application:
**02.11.83 Bulletin 83/44**

(45) Publication of the grant of the patent:
**27.07.88 Bulletin 88/30**

(84) Designated Contracting States:
**BE DE FR GB**

(56) References cited:
**EP-A-0 021 429**
**GB-A-2 046 461**
**US-A-4 072 528**

(73) Proprietor: **E.I. DU PONT DE NEMOURS AND COMPANY**
**1007 Market Street**
**Wilmington Delaware 19898 (US)**

(72) Inventor: **Neiss, Melvin Alan**
**R. D. 1 Cedar Grove Road Box 26**
**Annandale New Jersey 08801 (US)**
Inventor: **Woodruff, Robert Wilson**
**11 Fairview Avenue**
**East Brunswick New Jersey 08816 (US)**

(74) Representative: **Werner, Hans-Karsten, Dr. et al**
**Deichmannhaus am Hauptbahnhof**
**D-5000 Köln 1 (DE)**

Courier Press, Leamington Spa, England.

# 0 092 782

**Description**

This invention relates to an overcoated photohardenable element. More particularly this invention relates to an overcoated photohardenable element having protuberances in the overcoat layer. This invention also relates to processes for using the overcoated photohardenable element.

Single layer and multilayer photohardenable elements are known. Such photohardenable elements are becoming increasingly useful for various printing and proofing uses as well as in the formation of photomasks. Some of these photohardenable elements work in the positive mode, i.e., they provide an exact duplicate of the original image. In order to prepare an exact duplicate image, however, the image-bearing film or transparency must be placed or brought into uniform optical contact with the rawstock photohardenable layer. Generally the photohardenable film and the image-bearing surface are placed in a vacuum frame and then imagewise exposed. In many instances due to poor drawdown the image-bearing film does not achieve uniform optical contact, and the image formed is distorted.

The European Patent Application 0 021 429 discloses a photopolymerizable material for photocopying and a process for the preparation of relief images. This material is used for the preparation of printing formes having no cover layer which inhibits access of oxygen. The photopolymerizable layer of this printing formes contain a polymerizable compound and initiator and a polymeric binder as well as a finely-divided inorganic pigment and the average particle size of which is at least so thick as the photo copy layer.

In GB—A—2,046,461 a method is disclosed for producing a photosensitive printing plate. The outer photosensitive layer contains particles of finely-divided material. Upon evaporation of the solvent from the photosensitive layer individual particles of the finely-divided material remain on the surface as minute protrusions in the outermost layer.

The photohardenable films having protective cover sheets or an outer overcoating are particularly useful for making exact duplicates of the image. The outer layer is relatively hard so that the image-bearing film does not adhere thereto. After imagewise exposure and development this protective outer layer is no longer present and the photohardenable layers of many of these elements still have some tackiness which makes them easily damaged when touched, susceptible to dirt pickup, and adherent to adjacent elements on storage.

An object of this invention is to provide photohardenable elements which in the rawstock state have good vacuum drawdown and in their processed state are substantially nontacky.

In accordance with this invention there is provided a photohardenable element comprising a support bearing in order one or two photohardenable layers the first layer having a maximum thickness of 8 μm and the second layer, if present having a maximum thickness of 7 μm and comprising

a) an ethylenically unsaturated compound capable of forming a high polymer by free radical initiated, chain propagating, addition polymerization or benzophenone type groups,

b) an organic polymeric binder, and

c) a free radical generating addition polymerization initiator system activatable by actinic radiation; and a nonphotosensitive liquid removable layer which is at least partially soluble in or permeable to a solvent for the photohardenable layer, the photohardenable layer adjacent to the support being pigmented or dyed and having an optical density of at least 3.0 over at least the spectral range of 300 to 550 nm and the photohardenable layer present immediately beneath and in contact with the nonphotosensitive liquid removable layer having therein 5% to 50% by weight based on the weight of said photohardenable layer of substantially discrete, inert polymeric particles at least some of which protrude into the nonphotosensitive liquid removable layer, to cause protuberances in the nonphotosensitive liquid removable layer, the size of the particles being within the range of 0.1 to 10.0 μm, not more than 50% of the particles being below 3.5 μm and having a specific gravity substantially equivalent to that of the surrounding photohardenable layer in which they are present. The photohardenable elements of this invention can be manufactured by a process comprising

(1) coating onto a support a photohardenable or nonphotosensitive, solvent-soluble composition and drying the composition to form a layer no more than 15 μm in thickness and having an optical density of at least 3.0 over at least the 300 to 550 nm region of the spectrum; optionally

(2) coating on dry layer (1) an emulsion formed from (a) a solution containing at least one ethylenically unsaturated monomeric compound and at least one photoinitiator and (b) a solution containing at least one polymeric binder, and drying layer (2), layer (1) or layer (2), if present, containing substantially discrete inert particles having sizes within the range of 0.1 to 10.0 μm, not more than 50% of the particles by volume being below 3.5 μm and having a specific gravity substantially equivalent to that of the photohardenable layer (1) or (2) and

(3) overcoating the uppermost photohardenable layer with a liquid developable nonphotosensitive solution and drying said layer whereby at least some of the inert particles protrude into the nonphotosensitive layer causing protuberances therein.

The photohardenable elements of the invention are useful in many variations or configurations all of which have a support and an outer nonphotosensitive liquid removable overcoat layer. The term "photohardenable" means those materials containing ethylenically unsaturated or benzophenone-type groups in which an increase in molecular weight is caused by exposure to actinic radiation.

2

Photohardenable materials include photopolymerizable as well as photocrosslinkable and photodimerizable compositions. The elements contain at least one pigmented or dyed layer. A single layer or multiphotohardenable layers can be present between the support and overcoat layers. The substantially discrete, inert particles or beads, which are described more fully below, are present in the photohardenable layer immediately below the outer nonphotosensitive layer, which in the element containing multiphotohardenable layers is a clear layer, i.e., transparent or translucent. The phrase "inert particles or beads" means that the particles or beads present in the photohardenable layer of the element do not affect the photographic properties thereof. In the photohardenable element containing a single photohardenable layer the particles must be present in the photohardenable layer which is pigmented. In still another element, a clear photohardenable layer containing the particles is present above a pigmented nonphotosensitive layer. In all element configurations the particles protrude into the overcoat layer causing protuberances in said layer. Generally the number of protuberances ranges from about $1 \times 10^6$ to $10 \times 10^6$ protuberances per square inch ($0.15 \times 10^6$ to $1.5 \times 10^6$ protuberances per square cm.) and more.

U.S. Patent 4,162,162 describes a photopolymerizable element having two photopolymerizable layers, 6 to 15 µm total thickness, bottom layer pigmented, upper layer clear (as described in Example 7); U.S. Patent 4,229,517 describes a single pigmented photopolymerizable layer, maximum thickness 8 µm, preferably 3 to 6 µm; and Fan U.S. Patent 4,311,784 describes a nonphotosensitive solvent-soluble dye or pigment-containing layer having an optical density of at least 3.0 in the visible region of the spectrum and a maximum dry thickness of 15 µm as the bottom layer and an upper photosensitive layer having a maximum dry thickness of 8 µm preferably 3 to 6 µm.

A preferred element contains two photohardenable layers between the support and the outer nonphotosensitive layer, the lower layer being pigmented and having a thickness of no more than 6 µm and an optical density greater than 3.0 over at least the 300 to 550 nm region of the spectrum, and the upper clear photopolymerizable layer, 3 to 6 µm in thickness, containing the discrete particles.

The ingredients of the above-described elements are described in detail in the respective patents. The photohardenable layers contain (a) an ethylenically unsaturated compound capable of forming a high polymer by free radical initiated, chain propagating, addition polymerization or benzophenone type groups, 10 to 30% by weight, preferably 12 to 20% by weight; (b) an organic polymeric binder, 10 to 60% by weight, (c) a free radical generating addition polymerization initiator system activatable by actinic radiation, 0.1 to 20% by weight. Depending on the particular element used, (d) an actinic radiation absorbing material in an amount of 0 to 40% by weight can be present in a photohardenable or nonpolymerizable layer in such concentration to impart an optical density to the layer of at least 3.0 over at least the spectral range of 300 to 550 nm.

In the preferred element described above containing two photohardenable layers, the pigmented lower photohardenable layer contains a sensitizer in a sensitizing amount, e.g., as described in U.S. Patent 4,162,162, column 2, lines 4 to column 3, line 34 and column 4, line 56 to column 6, line 65; a photoinhibitor compound of the type described in U.S. Patent 4,198,242, column 7, line 31 to column 9, line 8.

The photoinhibitor is ordinarily employed in concentrations of about 0.004 to about 0.7 part by weight per part of photopolymerizable composition, preferably about 0.10 to about 0.35 part by weight per part of photopolymerizable composition.

Useful unsaturated monomers (a) as described above are disclosed, for example, in U.S. Patent 4,229,520, column 7, line 46 to column 8, line 3. Some additional unsaturated monomers include: di - (3 - methacryloxy - 2 - hydroxypropyl)ether of bisphenol-A, di(2 - methacryloxyethyl)ether of bisphenol-A, di - (3 - acryloxy - 2 - hydroxypropyl)ether of bisphenol-A, di - (2 - acryloxyethyl)ether of bisphenol-A, di - (3 - methacryloxy - 2 - hydroxypropyl)ether of tetrachloro bisphenol-A, di(2 - methacryloxyethyl)ether of tetrachloro bisphenol-A, di - (3 - methacryloxy - 2 - hydroxypropyl)ether of tetrabromo bisphenol-A, di - (2 - methacryloxyethyl)ether of tetrabromo bisphenol-A, di - (3 - methacryloxy - 2 - hydroxypropyl)ether of 1,4 - butanediol, di - (3 - methacryloxy - 2 - hydroxypropyl)ether of diphenolic acid. Useful polymeric binders (b) are disclosed in column 8, line 10 to column 9, line 27 of the same patent; useful photoinitiators (c) in column 5, line 38 to column 6, line 27 of the same patent; and useful actinic radiation absorbers (d) in column 6, line 31 to column 7, line 31 of the same patent.

As stated above, a single photohardenable layer containing a dye, pigment or an actinic radiation absorber; two photohardenable layers, the lower layer being pigmented and both layers absorbing actinic radiation; or a lower nonphotosensitive layer and upper photohardenable can be present on a suitable support, e.g., a rigid or flexible sheet, e.g., paper, plastic, etc. or metal. The major components of the photohardenable layer have been described above.

Suitable lower nonphotosensitive layers when used are thin, solvent-soluble, opaque organic polymeric or colloid layers (film forming materials) which remain adhered to the support in the image areas of the exposed photohardenable layer. The nonphotosensitive layer typically contains a binder along with other minor constituents such as plasticizers, coating aids and in some instances tackifiers. The binder is preferably solid at 50°C and is compatible with the incorporated colorant, if present. Examples of binders include: nonelastomeric binders both thermoplastic and nonthermoplastic, as disclosed in U.S. Patent 3,060,023, e.g., cellulose ethers or esters; polyalkylene ethers; condensation polymers of glycols with dibasic acids; polymers and copolymers of vinyl esters; acrylic acids and esters; polyvinyl alcohol; cellulose; phenolic resins; and the like. Other binders, including a number of vinylidene polymers, are disclosed in U.S. Patents 2,760,863 and 2,791,504. Still other useful binders are the N-methoxymethyl polyhexamethylene adipamide mixtures of British Patent 826,272, the polyester, polyacetal or mixed polyesteracetal mixtures of U.S. Patent 2,892,716; the fusible polyvinyl alcohol derivatives of U.S. Patent 2,902,365; the fusible blends of selected organic-soluble, base-soluble cellulose derivatives of U.S. Patent 2,902,365; the fusible blends of selected organic-soluble, base-soluble cellulose derivatives of U.S. Patent 2,927,022; the polyvinyl acetals having extralinear vinylidene groups of U.S. Patent 2,902,710; the linear polyamides containing extralinear N-acrylyloxymethyl groups of U.S. Patent 2,972,540.

Elastomer rubber type polymers, both natural and synthetic, may be used, e.g., isobutylene, Thiokol A, nitrile rubbers, butyl rubber, chlorinated rubbers, polymers of butadiene, poly(vinylisobutylether), isoprene and random, teleblock and block copolymers, terpolymers or higher polymers, e.g., butadiene copolymerized with styrene, isoprene and neoprene, silicone elastomers, acrylic containing elastomers, etc. in various proportions.

Particularly preferred as binders are nonelastomeric, acidic, polymeric, organic compounds since the composition resulting is developable in solely aqueous alkaline solvent devoid of organic solvents. This is advantageous since organic solvents are costly, may be hazardous with respect to toxicity and/or flammability, may become scarce due to petrochemical shortages, and may pollute the air and water.

One class of film-forming binders which is soluble in aqueous alkaline media and is useful in the compositions of the present invention is vinyl addition polymers containing free carboxylic acid groups, which are prepared from 30 to 94 mole percent of one or more alkyl acrylates and 70 to 6 mole percent of one or more α-β-ethylenically unsaturated carboxylic acids, and more preferably prepared from 61 to 94 mole percent of two alkyl acrylates and 39 to 6 mole percent of an α-β-ethylenically unsaturated carboxylic acid. Suitable alkyl acrylates for use in preparing these polymeric binders include methyl acrylate, ethyl acrylate, propyl acrylate, butyl acrylate, methyl methacrylate, ethyl methacrylate, butyl methacrylate, etc. Suitable α-β-ethylenically unsaturated carboxylic acids include acrylic acid, methacrylic acid and the like. Binders of this type, including their preparation, are described in DE—A—2,320,849, published November 8, 1973.

The advantages of using acidic binders can also be obtained by selecting a preformed, compatible macromolecular polymeric binding agent which is a copolymer of (1) a styrene-type of a vinyl monomer and (2) an unsaturated carboxy-containing monomer, as described in detail in British Patent 1,361,298.

Suitable support materials to which the contiguous layer remains adhered include films composed of high polymers, which are cast as films from molten polymer, such as polyamides, e.g., polyhexamethylene sebacamide, polyhexamethylene adipamide; polyolefins, e.g., polypropylene; polyesters, e.g., polyethylene terephthalate, polyethylene terephthalate/isophthalate; vinyl polymers, e.g., vinyl acetals, vinylidene chloride/vinyl chloride copolymers, polystyrene, polyacrylonitrile; and cellulosics, e.g., cellulose acetate, cellulose acetate/butyrate, cellophane. A particularly preferred support material is polyethylene terephthalate film of the kind described in Alles et al., U.S. Patent 2,627,088, and Alles, U.S. Patent 2,779,684, with or without the surface coating described in the former patent. The support may have a resin "sub" or other layer thereon which may or may not be soluble and which for purposes of this invention is considered part of the support. However, the total thickness of the contiguous layer and any soluble sub or underlayer should not exceed 0.0006 inch (0.015 mm). By "soluble" is meant solubility in a solvent in which the contiguous layer is developable. Preferred soluble sub layers have a thickness not exceeding about 0.0002 inch (0.0005 mm). Where the particular application does not require that the base support be transparent, the contiguous composition may usefully be coated on an opaque support, such as paper, especially water-proof photographic paper; thin metal sheets, especially aluminum and copper sheets, cardboard, etc.

The nonphotosensitive layer present as the outer layer of the elements is a polymeric material, e.g., polyvinyl alcohol, gelatin, etc., coated in solution over the photohardenable stratum containing the discrete, inert particles or beads to leave, after removal of solvent, a dry overcoat layer, which depending on its composition, is at least partially soluble in or permeable to the solvent for the photohardenable layer. Some nonphotosensitive layers are described in U.S. Patent 3,458,311.

Particles or beads are present in the photohardenable layer of the element immediately below the top nonphotosensitive layer and cause protuberances in the nonphotosensitive layer. The particles or beads are discrete, substantially nonagglomerating in the solvent used in the preparation of the photohardenable layer. The particles have sizes within the range of 0.1 to 10 μm, not more than 50% of the particles by volume being below 3.5 μm. If the particle size is too large undesirable pigmented spots may be seen in the processed film. Suitable particles which preferably are polymeric include: tetraethylene glycol dimethacrylate (TEDMA), trimethylolpropane triacrylate (50 to 25)/methylmethacrylate (50 to 75), trimethylolpropane triacrylate/styrene, trimethylolpropane triacrylate (25 to 10)/triethyleneglycol diacrylate (75 to 90), triethylene glycol dimethacrylate/methylmethacrylate, tetraethylene glycol dimethacrylate/methylmethacrylate, polyethylene etc. Preferred particles are discrete, substantially nonswellable, crosslinked polymeric beads which are nonagglomerating in solvent for the monomer or monomers used in the preparation thereof. Homopolymers of tri- and tetraacrylate and tri- and tetramethacrylate monomers, copolymers of said tri- and tetraacrylate and tri- and tetramethacrylate monomers, copolymers of one of said tri- and tetraacrylate or said tri- and tetramethacrylate monomers and up to 50% by weight of at least one monomer having one terminal ethylenic group, copolymers of one of said tri- and tetraacrylate or said tri- and tetramethacrylate monomers and up to 75% by weight of at least one monomer having two terminal ethylenic groups or three terminal ethylenic groups different from said tri- and tetraacrylate or tri- and tetramethacrylate monomers. These preferred crosslinked polymeric beads are described in Cohen and Lazaridis U.S. Application Serial No. 370,992, filed April 22, 1982 entitled "Crosslinked Triacrylate Polymer Beads".

The particles or beads are generally present in the photohardenable layer in amounts of 1 to 50% by weight based on the weight of the layer, preferably 5 to 10% by weight. The amount present must not affect the photographic properties of the photohardenable layer.

The best mode for carrying out the invention is illustrated in Example 4 wherein the particles in the upper photohardenable layer, which extend into the nonphotosensitive overcoat layer and cause protuberances therein, are trimethylolpropane triacrylate polymer having a median particle size of about 4.0 µm by volume.

The photohardenable elements of this invention are useful in preparing films for exposing printing plates particularly in process color printing and for preparing color proofs from separation negatives. In printing plate applications, an important use is in a two exposure imaging system to yield a positive working photopolymer litho film. In such use a suitable element is (1) exposed imagewise to actinic radiation, the element is (2) reexposed to actinic radiation above 400 nm, and the nonphotosensitive liquid removable layer and the unpolymerized areas of the photohardenable layers are (3) removed by liquid development. Inert particles remain present in the polymerized areas of the photohardenable layer. Negative working photopolymer litho films can also be prepared. The photohardenable elements in the rawstock state exhibit good vacuum drawdown. In their processed state the elements are substantially nontacky.

The following examples illustrate the invention wherein the parts and percentages are by weight. The polymeric molecular weights are expressed as number average molecular weights ($\bar{M}n$). The $\bar{M}n$ for the polymers described herein can be determined by gel permeation chromatography employing a polybutadiene standard or other standard known to those skilled in the art. In the examples tackiness (or nontackiness) is determined as follows: several sheets of exposed and developed film are stacked one above the other under a 1000 g weight and are maintained at 80% R.H. and 80°F (26.7°C) for 3 days. The films are then checked for tackiness. If a film sheet sticks to an adjacent sheet it is considered to be tacky.

Example 1

A photopolymerizable composition, containing 32.5% solids, is prepared from the following ingredients:

| Ingredient | | Weight (g) |
|---|---|---|
| Trimethylolpropane triacrylate | | 84.1 |
| Tetraethylene glycol dimethacrylate | | 84.1 |
| Copolymer of styrene/maleic anhydride (1.4/l) Mol. Wt., ca. 10,000 | | 341.2 |
| Titanium acetyl acetonate, 75% in isopropanol | | 24.1 |
| Ethyl tetrahydroquinoline chromanone | | 5.6 |
| 1-(2'-Nitro-4',5'-dimethoxy)phenyl-1-(4-t-butylphenoxy)ethane | | 50.3 |
| Bis(2-o-chlorophenyl-4,5-bis(3'-methoxyphenyl)imidazole | | 27.9 |
| Bis(2-o-chlorophenyl-4,5-bis-phenyl)imidazole | | 27.9 |
| 1,4,4-Trimethyl-2,3-diazabicyclo[3.2.2]-non-2-ene-N,N'-dioxide | | 0.57 |
| Milled dispersion of | | |
| (a) Sterling® carbon black | 45 parts | 497.7 |
| (b) 80% of terpolymer: ethyl acrylate (56.0), methyl methacrylate (37.0), acrylic acid (7.0) Acid No. 76—85; Mol wt. ca. 260,000, and 20% of a copolymer of styrene/maleic anhydride (1.4/l) Mol. Wt. ca. 10,000 | 54 parts | |
| (c) Stearic acid | 1 part | |
| Ethyl Cellosolve® | | 188.5 |
| Methylene chloride | | 2167.7 |

This composition is thoroughly mixed, and is then machine coated on the resin subbed side of a 0.004 inch (0.01 cm) polyethylene terephthalate film support at 124 ft/min (37.8 m/min). The coating is dried at 170°F (77°C) to yield a black photopolymer layer with a coating weight of ~50 mg/dm² (about 5.0 μm in thickness).

A second photopolymer composition is prepared by emulsifying the following Solutions A and B in a 2 stage Gaulin Homogenizer at 6000 psi (41.37 N/mm²).

Solution A is prepared by thoroughly mixing the following ingredients:

| Ingredient | Weight (g) |
|---|---|
| Tetraethylene glycol dimethacrylate | 43.0 |
| Trimethylolpropane triacrylate | 43.0 |
| Ethyl tetrahydroquinoline chromanone | 2.9 |
| 1-(2'-Nitro-4',5'-dimethoxy)phenyl-1-(4-t-butylphenoxy)ethane | 26.0 |
| Bis(2-o-chlorophenyl-4,5-bis(3'-methoxyphenyl)imidazole | 14.5 |
| Bis(2-o-chlorophenyl-4,5-bis-phenyl)imidazole | 14.5 |
| 1,4,4-Trimethyl-2,3-diazabicyclo[3.2.2]-non-2-ene-N,N'-dioxide | 0.28 |
| Methylene chloride | 208.0 |

Solution B is prepared by thoroughly mixing the following ingredients:

| Ingredient | Weight (g) |
|---|---|
| Acrysol® I-98 (acrylic copolymer supplied as a latex, Rohm & Haas Co., Philadelphia, Pa.) | 510.0 |
| Rhoplex® B-505 (acrylic latex emulsion, Rohm & Haas Co., Philadelphia, Pa.) | 382.0 |
| 40% Dispersion of submicron poly(ethylene) particles in water | 286.0 |
| 10% Solution of octylphenoxy polyethoxy ethanol, dispersing agent | 86.0 |
| Ammonium hydroxide (28% solution) | 13.0 |
| Distilled water | 1888.0 |

The second photopolymer composition is stirred for 15 minutes. 44 Grams of trimethylolpropane triacrylate polymer beads having a particle median population diameter of 1.8 μm and 4.0 μm median volume diameter and specific gravity of about 1.3 are added to 3507 grams of the emulsion of Solutions A and B, and the photopolymer composition containing the beads is milled in a Kady Mill (Kinetic Dispersion Corp., Buffalo, N.Y.) for 5 minutes, followed by 52 grams of a 5% solution of "FC-128", anionic fluorocarbon surfactant from 3M Co. The particle-containing photopolymer composition is stirred for an additional 30 minutes.

This composition is coated contiguous to the first photopolymerizable layer at 30 ft/min. (914.4 cm/min). The resulting clear layer with a coating weight of ca. 40 mg/dm² (about 4.0 μm in thickness) is dried at 220°F (104°C).

An overcoat composition (~5.0% solids) is prepared as follows:

# 0 092 782

| Ingredient | Weight (g) |
|---|---|
| Distilled water | 2266.0 |
| Poly(vinyl alcohol) 13% solution | 1210.0 |
| Polyvinyl pyrrolidone (70)/vinyl acetate(30) copolymer | 17.3 |
| "FC-128" (Anionic fluorocarbon surfactant from 3M Co.) (5% solution) | 7.0 |

The composition is thoroughly mixed and is coated over the dry, clear photopolymerizable layer at 40 ft/min (12.19 m/min). The resulting layer is dried at 220°F (104°C). The layer thickness is about 1.3 μm.

The multilayered photopolymer element is exposed for 20 seconds to a 4 KW xenon arc light source manufactured by MacBeth Arc Light Co., Philadelphia, PA at a distance of 60 inches (152.4 cm) through a photographic positive image in contact with the overcoat layer. The positive image is then removed, and the element is reexposed for 60 seconds to the same light source through a cut-off filter which absorbs all the light below 400 nm. The film is then processed through an automatic processor described in U.S. Patent 4,142,194, at 5 ft/min (152.4 cm min) developed at 85°F (29.4°C) and rinsed at 100°F (37.8°C) to produce an exact duplicate of the original positive image. The element exhibits excellent drawdown in the exposure vacuum frame within 30 seconds and the surface of the processed element is determined to be nontacky by the tackiness test described above.

A control element is prepared by the procedure described above except that no polymer beads are added to the clear photopolymer layer. The control element takes 5 minutes to drawdown in the vacuum frame and the surface of the processed element is extremely tacky after storage under the conditions of the tackiness test described above.

Example 2

Example 1 is repeated except that the following polymer beads are present in the upper photopolymer layer of their respective element.

Sample A: Trimethylolpropane trimethacrylate (100), median diameter of 1.16 μm (population) and 2.0 μm (volume) (some aggregates, many fines);

Sample B: Styrene(90)/trimethylolpropane trimethylacrylate (10), average diameter of 1.32 μm (population) and 2.73 μm (volume); and

Sample C: Methylmethacrylate(95)/tetraethylene glycol dimethacrylate(5), average diameter of 2.9 μm (population) and 5.5 μm (volume).

After exposing and developing the elements as described in Example 1 the following results with respect to drawdown in the vacuum frame and tackiness are achieved.

| | Drawdown (sec) | Tack |
|---|---|---|
| Sample A | 30 | nontacky |
| Sample B | greater than 30 | slight tack under conditions of tackiness test |
| Sample C | 30 | nontacky |

Sample B's slower drawdown time is due to the smaller size beads causing fewer protuberances in the overcoat.

Example 3

Four photopolymer elements are prepared as described in Example 1 except that the clear photopolymer compositions are prepared by emulsifying below-listed Solutions A and B in the Gaulin Homogenizer, and after stirring the emulsion, 27.5 g of the following polymer beads are added:

Sample A: Styrene(50)/trimethylolpropane triacrylate(50), average diameter of 1.33 μm (population) and 1.55 μm (volume) (some aggregates);

Sample B: Methylmethacrylate(10)/trimethylolpropane triacrylate(90), median diameter of 1.38 μm (population) and 2.29 μm (volume) (some aggregates);

Sample C: Methylmethacrylate(75)/tetraethylene glycol dimethacrylate(25), median diameter of 2.98 μm (population) and 5.14 μm (volume);

Sample D: Trimethylolpropane triacrylate(100), median diameter of 1.55 μm (population) and 4.26 μm (volume).

The photopolymer solutions containing the polymer beads are milled in a Kady Mill (Kinetic Dispersion

7

# 0 092 782

Corp., Buffalo, New York) for 5 minutes after which 33 g of a 5% solution of the anionic fluorocarbon surfactant described in Example 1 is added with additional stirring.

Solution A is prepared by thoroughly mixing the following ingredients:

| Ingredient | Weight (g) |
|---|---|
| Tetraethylene glycol dimethacrylate | 28.66 |
| Trimethylolpropane triacrylate | 28.66 |
| Ethyl tetrahydroquinoline chromanone | 1.93 |
| 1-(2'-Nitro-4',5'-dimethoxy)phenyl-1-(4-t-butylphenoxy)ethane | 17.30 |
| Bis(2-o-chlorophenyl-4,5-bis(3'-methoxyphenyl)imidazole | 9.66 |
| Bis(2-o-chlorophenyl-4,5-bis-phenyl)imidazole | 9.66 |
| 1,4,4-Trimethyl-2,3-diazabicyclo[3.2.2]-non-2-ene-N,N'-dioxide | 0.187 |
| Methylene chloride | 138.66 |

Solution B is prepared by thoroughly mixing the following ingredients:

| Ingredient | Weight (g) |
|---|---|
| Acrysol® I-98 (acrylic copolymer supplied as a latex, Rohm & Haas Co., Philadelphia, PA) | 340.0 |
| Rhoplex® B-505 (acrylic latex emulsion, Rohm & Haas Co., Philadelphia, PA) | 254.66 |
| 40% Dispersion of submicron poly(ethylene) particles in water | 190.66 |
| 10% Solution of octylphenoxy polyethoxy ethanol, dispersing agent | 57.33 |
| Ammonium hydroxide (28% solution) | 13.66 |
| Distilled water | 1258.66 |

After exposing and developing the elements as described in Example 1 the following results with respect to drawdown in the vacuum frame and tackiness are achieved.

| | Drawdown (sec) | Tack |
|---|---|---|
| Sample A | 30 | nontacky |
| Sample B | 30 | nontacky |
| Sample C | 30 | nontacky |
| Sample D | 30 | nontacky |

Sample D illustrates a preferred bead particle size. Some pigmented spots are present in Samples A and C caused by particle aggregates and too large beads, respectively.

Example 4

The following photopolymerizable composition is prepared from the following ingredients:

| Ingredient | | Weight (g) |
|---|---|---|
| Methylene chloride | | 142,244.0 |
| Ethyl Cellosolve® | | 12,429.0 |
| Trimethylolpropane triacrylate | | 5,047.0 |
| Tetraethylene glycol dimethacrylate | | 5,047.0 |
| Copolymer of styrene/maleic anhydride (1.4/l) Mol. Wt., ca. 10,000 | | 20,415.0 |
| Titanium acetyl acetonate, 75% in isopropanol | | 1,227.0 |
| Ethyl tetrahydroquinoline chromanone | | 333.64 |
| 1-(2'-Nitro-4',5'-dimethoxy)phenyl-1-(4-t-butylphenoxy)ethane | | 3,017.6 |
| Bis(2-o-chlorophenyl-4,5-bis(3'-methoxyphenyl)imidazole | | 1,676.0 |
| Bis(2-o-chlorophenyl-4,5-bis-phenyl)imidazole | | 1,675.0 |
| 1,4,4-Trimethyl-2,3-diazabicyclo[3.2.2]-non-2-ene-N,N'-dioxide | | 34.25 |
| Milled dispersion of<br>(a) Sterling® carbon black | 45 parts | 29,951.0 |
| (b) 80% of terpolymer: ethyl acrylate (56.0), methyl methacrylate (37.0), acrylic acid (7.0) Acid No. 76—85; Mol wt. ca. 260,000, and 20% of a copolymer of styrene/maleic anhydride (1.4/l) Mol. Wt. ca. 10,000 | 54 parts | |
| (c) Stearic acid | 1 part | |

This composition is thoroughly mixed, and is then machine coated on the resin subbed side of a 0.004 inch (0.01 cm) polyethylene terephthalate film support at 120 ft/min (36.58 m/min). The coating is dried at 170°F (76.7°C) to yield a black photopolymer layer with a coating weight of ~50 mg/dm$^2$ (5 µm in thickness).

A second photopolymer composition is prepared by emulsifying the following Solutions A and B in a single stage Gaulin Homogenizer at 3000 psi (20.68 N/mm$^2$). Solution A is prepared by thoroughly mixing the following ingredients:

| Ingredient | Weight (g) |
|---|---|
| Tetraethylene glycol dimethacrylate | 1872.0 |
| Trimethylolpropane triacrylate | 1874.0 |
| Ethyl tetrahydroquinoline chromanone | 125.0 |
| 1-(2'-Nitro-4',5'-dimethoxy)phenyl-1-(4-t-butylphenoxy)ethane | 1125.0 |
| Bis(2-o-chlorophenyl-4,5-bis(3'-methoxyphenyl)imidazole | 624.0 |
| Bis(2-o-chlorophenyl-4,5-bis-phenyl)imidazole | 624.0 |
| 1,4,4-Trimethyl-2,3-diazabicyclo[3.2.2]-non-2-ene-N,N'-dioxide | 12.2 |
| Methylene chloride | 9072.0 |

Solution B is prepared by thoroughly mixing the following ingredients:

| Ingredient | Weight (g) |
|---|---|
| Acrysol® I-98 (acrylic copolymer supplied as a latex, Rohm & Haas Co., Philadelphia, Pa.) | 22,228.0 |
| Rhoplex® B-505 (acrylic latex emulsion, Rohm & Haas Co., Philadelphia, Pa.) | 16,648.0 |
| 40% Dispersion of submicron poly(ethylene) particles in water | 12,474.0 |
| 10% Solution of octylphenoxy polyethoxy ethanol, dispersing agent | 3,742.0 |
| Ammonium hydroxide | 450.0 |
| Distilled water | 82,330.0 |

The second photopolymer composition is stirred for 30 minutes, and 2.104 grams of 5% "FC-128", anionic fluorocarbon surfactant from 3M Co., are added. 1.905 Grams of trimethylolpropane triacrylate polymer beads having a particle median diameter of 1.8 μm (population) and 4.0 μm (volume) and specific gravity of about 1.3, 234 grams of "FC-128", and 16,955 grams of distilled water are mixed separately and the resulting solution is milled in a Greerco colloid mill, Creerco Corp., Hudson, New Hampshire, for 10 minutes at 0.001 inch (0.025 mm) gap setting. The milled solution is then added to the emulsion described earlier. The polymer particle-containing photopolymer composition is stirred for more than 30 minutes.

The stirred composition is coated contiguous to the first photopolymerizable layer at 120 ft/min (36.58 m/min). The resulting layer with a coating weight of ca. 40 mg/dm² (about 4.0 μm in thickness) is dried at 225—250°F (107 to 121°C).

An overcoat composition (~4.0% solids) is prepared as follows and is coated at 130 ft/min (39.62 m/min). The resulting layer. is dried at 220°F (104°C). The layer thickness is about 1.3 μm.

| Ingredient | Weight (g) |
|---|---|
| Distilled water | 371,498.0 |
| Poly(vinyl alcohol) (13% solution) | 146,388.0 |
| Polyvinyl pyrrolidone(70)/vinyl acetate(30) copolymer (20% solution) | 10,485.0 |
| "FC-128" (Anionic fluorocarbon surfactant from 3M Co.) (5% solution) | 844.0 |

The element, after being exposed and processed as described in Example 1, is nontacky as determined by the tackiness test described above with few black specks. The element exhibits excellent drawdown within 30 seconds.

Example 5

A photopolymerizable composition is prepared by thoroughly mixing Solutions A, B, and 824 g of Dispersion C in a Kady Mill for 30 minutes. 1250 grams of water are then added to the mixture with gentle stirring to give a photopolymer composition containing 14% solids.

Solution A is prepared by gently mixing the following ingredients:

| Ingredient | Weight (g) |
|---|---|
| 10% Solution of an interpolymer formed from N-tert.-octyl acrylamide (40%), methyl methacrylate (34%), acrylic acid (16%), hydroxypropyl methacrylate (6%), and t-butylaminoethyl methacrylate (4%) Mol. Wt. ca. 50,000 | 2720.0 |
| 40% Dispersion of submicron poly(ethylene) particles in water (Misco Prod. Co.) | 105.0 |
| Lactic acid titanium chelate having the formula: | 23.0 |

$$NH_4^{+-}OC \quad CHCH_3$$
$$\qquad \| \quad \|$$
$$OH \quad O \quad O$$
$$\qquad \searrow \downarrow \swarrow$$
$$Ti$$
$$\qquad \swarrow \uparrow \searrow$$
$$O \quad O \quad OH$$
$$\qquad | \quad \|$$
$$H_3CH \quad CO^- \quad NH_4^+$$

| Ingredient | Weight (g) |
|---|---|
| 10% Solution of octylphenoxy polyethoxy ethanol, dispersing agent | 36.0 |

Solution B is prepared by thoroughly mixing the following ingredients:

| Ingredient | Weight (g) |
|---|---|
| Methylene chloride | 310.0 |
| Trimethylolpropane triacrylate | 170.0 |
| Michler's ketone | 8.6 |
| Ethyl Michler's ketone | 26.4 |
| Bis(2-o-chlorophenyl-4,5-bis(3'-methoxyphenyl)imidazole | 33.6 |
| Bis(2-o-chlorophenyl-4,5-bisphenyl)imidazole | 33.6 |
| 2,2'-Dihydroxy-4-methoxy benzophenone | 14.6 |
| 2-(Silbyl-4'')-(naphtho-1',2':4,5)-1,2,3-triazole-2''-sulfonic acid phenyl ester | 0.70 |
| 7-(4'-Chloro-6'-diethylamino-1'3',5'-triazone-2'-yl) amino-3-phenyl coumarin | 14.6 |

Dispersion C is prepared by attritor milling the following ingredients followed by draining for 2 hours.

| Ingredient | Weight (g) |
|---|---|
| Interpolymer described in Solution A above | 45.000.0 |
| Permanent Yellow G.G. Pigment (C.I. #17) | 3690.0 |

1.5 Grams of trimethylolpropane triacrylate polymer beads having a particle median diameter of 1.4 µm (population) and 4.6 µm (volume) and specific gravity of about 1.3, are added to 150 g of the above-described photopolymer composition containing 14% solids, in a Waring Blendor and blended at 70 V for 5 minutes. To 78.0 g of the blended solution are added 1.2 grams of a 5% solution of the "FC-128" surfactant described in Example 1 followed by blending at 30 V for 5 minutes.

The resulting composition is then board coated on the resin subbed side of a 0.004 inch (0.01 cm) polyethylene terephthalate film support using a 0.002 inch (0.005 cm) doctor knife and dried using a heat gun to yield a yellow photopolymerizable layer having a coating weight of about 70 mg/dm² (7 μm in thickness). The dried yellow photopolymerizable element is overcoated as described in Example 1 and is designated Sample A.

A second sample (B) is prepared by overcoating another dried, yellow, photopolymerizable layer prepared as described above with the following overcoat:

| Ingredient | Weight (g) |
|---|---|
| Overcoat composition as in Example 1 | 100 |
| Distilled water | 100 |

After exposing for 30 seconds to a 4 KW xenon arc light source manufactured by MacBeth Arc Light Co., Philadelphia, PA at a distance of 60 inches (152.4 cm) through a photographic image and processing and developing the above-described single photopolymer layer containing elements as described in Example 1 except that the film is processed through the processor at 15 ft/min (4.57 m/min), the following results are achieved:

| | Drawdown (sec) | Tack |
|---|---|---|
| Sample A | 30 | nontacky |
| Sample B | 30 | nontacky |

The protuberances in the overcoat layer are about 2 to 3 μm.

Example 6

A photopolymer element is prepared as described in Example 1 except that the clear photopolymer composition is prepared by emulsifying 338 g and 3020 g of the below-listed Solutions A and B, in a Kady mill, and, after stirring, are added 51 grams of Eftofine® FT-800F, synthetic Fischer-Tropsch hydrocarbon wax particles manufactured by Dura Commodities Corporation, Harrison, NY, having a particle average size of about 2 μm and a maximum particle size of about 10 μm, specific gravity of 0.95 and melting point in the range of 113 to 118°C.

To the photopolymer solution containing the synthetic hydrocarbon wax particles are added 34 grams of a 5% solution of the anionic fluorocarbon surfactant described in Example 1 with stirring.

Solution A is prepared by thoroughly mixing the following ingredients:

| Ingredient | Weight (g) |
|---|---|
| Tetraethylene glycol dimethacrylate | 144.0 |
| Trimethylolpropane triacrylate | 145.0 |
| Ethyl tetrahydroquinoline chromanone | 9.6 |
| 1-(2'-Nitro-4',5'-dimethoxy)phenyl-1-(4-t-butylphenoxy)ethane | 86.8 |
| Bis(2-o-chlorophenyl-4,5-bis(3'-methoxyphenyl)imidazole | 48.1 |
| Bis(2-o-chlorophenyl-4,5-bis-phenyl)imidazole | 48.1 |
| 1,4,4-Trimethyl-2,3-diazabicyclo[3.2.2]-non-2-ene-N,N'-dioxide | 0.96 |
| Methylene chloride | 700.0 |

Solution B is prepared by thoroughly mixing the following ingredients:

| Ingredient | Weight (g) |
| --- | --- |
| Acrysol® I-98 (acrylic copolymer supplied as a latex, Rohm & Haas Co., Philadelphia, Pa.) | 1715.0 |
| Rhoplex® B-505 (acrylic latex emulsion, Rohm & Haas Co., Philadelphia, Pa.) | 1285.0 |
| 40% Dispersion of submicron poly(ethylene) particles in water | 963.0 |
| 10% Solution of octylphenoxy polyethoxy ethanol, dispersing agent | 289.0 |
| Distilled water | 6318.0 |

The element has a fast drawdown time of 15 seconds, and the processed element is nontacky after storage for 3 days under the conditions of the tackiness test described above.

## Claims

1. A photohardenable element comprising a support bearing in order one or two photohardenable layers the first layer having a maximum thickness of 8 μm and the second layer, if present having a maximum thickness of 7 μm and comprising

a) an ethylenically unsaturated compound capable of forming a high polymer by free radical initiated, chain propagating, addition polymerization or benzophenone type groups,

b) an organic polymeric binder, and

c) a free radical generating addition polymerization initiator system activatable by actinic radiation;

and a nonphotosensitive liquid removable layer which is at least partially soluble in or permeable to a solvent for the photohardenable layer, the photohardenable layer adjacent to the support being pigmented or dyed and having an optical density of at least 3.0 over at least the spectral range of 300 to 550 nm and the photohardenable layer present immediately beneath and in contact with the nonphotosensitive liquid removable layer having therein 5% to 50% by weight based on the weight of said photohardenable layer of substantially discrete, inert polymeric particles at least some of which protrude into the nonphotosensitive liquid removable layer, to cause protuberances in the nonphotosensitive liquid removable layer, the size of the particles being within the range of 0.1 to 10.0 μm, not more than 50% of the particles being below 3.5 μm and having a specific gravity substantially equivalent to that of the surrounding photohardenable layer in which they are present.

2. A photohardenable element according to claim 1 comprising a single photohardenable layer.

3. A photohardenable element according to claim 1 comprising two photopolymerizable layers the first layer having a thickness of no more than 6 μm and the second layer containing the polymeric particles having a thickness of 3 to 6 μm.

4. A photohardenable element according to claim 1 wherein the photohardenable layer present between the support and the upper photohardenable layer is replaced by a nonphotosensitive solvent-soluble dye or pigment-containing layer having an optical density of at least 3.0 in the visible region of the spectrum and a maximum dry thickness of 15 μm.

5. A photohardenable element according to claim 1 to 4, wherein the discrete inert polymeric particles consist of trimethylolpropane triacrylate, methylmethacrylate/trimethylolpropane triacrylate, styrene/trimethylolpropane triacrylate, methylmethacrylate/triethylene glycol dimethacrylate, triethylene glycol diacrylate/trimethylolpropane triacrylate or polyethylene.

6. A photohardenable element according to claim 5 wherein the polymeric particles are trimethylolpropane triacrylate polymer particles.

7. A process of forming a positive image comprising (1) exposing imagewise to actinic radiation a photohardenable element according to claim 1, (2) reexposing the element to actinic radiation above 400 nm, and (3) removing by liquid development the nonphotosensitive liquid removable layer and the unpolymerized areas of the photohardenable layer or layers, the discrete, inert polymeric particles being present in the polymerized areas of the photohardenable layer.

## Patentansprüche

1. Photohärtbares Element, umfassend einen Träger, der, in der angegebenen Reihenfolge, eine oder zwei photohärtbare Schichten, wobei die erste Schicht eine maximale Dicke von 8 μm besitzt und die zweite Schicht, sofern vorhanden, eine maximale Dicke von 7 μm besitzt, umfassend

a) eine ethylenisch ungesättigte Verbindung, die zur Bildung eines Hochpolymeren mittels durch freie

# 0 092 782

Radikale ausgelöster Kettenfortpflanzungs-Additionspolymerisation oder Gruppen des Benzophenon-Typs befähigt ist,

    b) ein organisches polymeres Bindemittel und

    c) einen freie Radikale erzeugenden Additionspolymerisations-Initiator,

und eine nicht lichtempfindliche, flüssig entfernbare Schicht, die wenigstens teilweise löslich in einem Lösungsmittel für die photohärtbare Schicht ist oder für ein solches Lösungsmittel wenigstens teilweise durchlässig ist, trägt wobei die dem Träger benachbarte photohärtbare Schicht pigmentiert oder gefärbt ist und eine optische Dichte von wenigstens 3,0 über wenigstens den Spektralbereich von 300 bis 550 nm hat und die unmittelbar unterhalb der nicht lichtempfindlichen, flüssig entfernbaren Schicht und in Kontakt mit dieser vorliegende Schicht 5 bis 50 Gew.-%, bezogen auf das Gewicht der photohärtbaren Schicht, im wesentlichen diskreter, inerter polymerer Teilchen in der Schicht enthält, von denen wenigstens einige in die nicht lichtempfindliche, flüssig entfernbare Schicht hineinragen und Vorsprünge in der nicht lichtempfindlichen, flüssig entfernbaren Schicht bewirken, wobei die Größe der Teilchen innerhalb des Bereichs von 0,1 bis 10,0 µm liegt und nicht mehr als 50% der Teilchen unterhalb von 3,5 µm liegen und die Teilchen ein spezifisches Gewicht besitzen, das im wesentlichen demjenigen der umgebenden photohärtbaren Schicht, in der sie vorliegen, äquivalent ist.

2. Photohärtbares Element nach Anspruch 1, umfassend eine einzelne photohärtbare Schicht.

3. Photohärtbares Element nach Anspruch 1, umfassend zwei photohärtbare Schichten, von denen die erste Schicht eine Dicke von nicht mehr als 6 µm hat und die zweite, die polymeren Teilchen enthaltende Schicht eine Dicke von 3 bis 6 µm hat.

4. Photohärtbares Element nach Anspruch 1, worin die zwischen dem Träger und der oberen photohärtbaren Schicht vorliegende lichthärtbare Schicht durch eine nicht lichtempfindliche, einen in einem Lösungsmittel löslichen Farbstoff oder ein Pigment enthaltende Schicht mit einer optischen Dichte von wenigstens 3,0 im sichtbaren Bereich des Spektrums und einer maximalen Dicke im trockenen Zustand von 15 µm ersetzt ist.

5. Photohärtbares Element nach den Ansprüchen 1 bis 4, worin die diskreten, inerten polymeren Teilchen aus Trimethylolpropantriacrylat, Methylmethacrylat/Trimethylolpropantriacrylat, Styrol/Trimethylolpropantriacrylat, Methylmethacrylat/Triethylenglycoldimethacrylat, Triethylenglycoldiacrylat/Trimethylolpropantriacrylat oder Polyethylen bestehen.

6. Photohärtbares Element nach Anspruch 5, worin die polymeren Teilchen Trimethylolpropantriacrylat-Polymer-Teilchen sind.

7. Verfahren zur Herstellung eines Positiv-Bildes, umfassend

    (1) das bildmäßige Einwirkenlassen einer aktinischen Strahlung auf ein photohärtbares Element nach Anspruch 1,

    (2) das erneute Einwirkenlassen einer aktinischen Strahlung oberhalb von 400 nm auf das Element und

    (3) das Entfernen der nicht lichtempfindlichen, flüssig entfernbaren Schicht und der unpolymerisierten Bereiche der photohärtbaren Schicht oder Schichten durch Flüssigentwicklung, wobei die diskreten, inerten polymeren Teilchen in den polymerisierten Bereichen der photohärtbaren Schicht vorliegen.

## Revendications

1. Un élément photodurcissible comprenant un support portant, dans cet ordre, une ou deux couches photodurcissables, la première couche ayant une épaisseur maximale de 8 µm et la seconde couche, si elle est présente, ayant une épaisseur maximale de 7 µm et comprenant:

    a) un composé éthyléniquement insaturé capable de former un haut polymère par polymérisation d'addition à propagation de chaîne amorcée par des radicaux libres ou des groupes de type de la benzophénone,

    b) un liant polymère organique, et

    c) un système initiateur de polymérisation d'addition engendrant des radicaux libres, activable par un rayonnement actinique;

et une couche non photosensible éliminable par un liquide, qui est au moins partiellement soluble dans, ou perméable à, un solvant de la couche photodurcissable, la couche photodurcissable adjacente au support étant pigmentée ou colorée et ayant une densité optique d'au moins 3,0 sur au moins la tranche spectrale de 300 à 550 nm, et la couche photodurcissable présente juste au-dessous et au contact de la couche non photosensible éliminable par un liquide renfermant 5% à 50% en poids, par rapport au poids de ladite couche photodurcissable, de particules polymères inertes sensiblement discrètes dont certaines au moins saillent dans la couche non photosensible éliminable par un liquide, en créant des protubérances dans la couche non photosensible éliminable par un liquide, la taille des particules étant comprise dans l'intervalle de 0,1 à 10,0 µm, pas plus de 50% des particules n'étant de taille inférieure à 3,5 µm, et leur densité étant sensiblement équivalente à celle de la couche photodurcissable environnante dans laquelle elles sont présentes.

2. Un élément photodurcissible selon la revendication 1, comprenant une seule couche photodurcissable.

14

3. Un élément photodurcissable selon la revendication 1, comprenant deux couches photodurcissables, l'épaisseur de la première couche n'étant pas supérieure à 6 μm et l'épaisseur de la seconde couche, qui contient les particules polymères, étant de 3 à 6 μm.

4. Un élément photodurcissable selon la revendication 1, dans lequel la couche photodurcissable présente entre le support de la couche photodurcissable supérieure est remplacée par une couche non photosensible pigmentée ou colorée, soluble dans un solvant, dont la densité optique est d'au moins 3,0 dans la région visible du spectre et dont l'épaisseur maximale à l'état sec est de 15 μm.

5. Un élément photodurcissable selon les revendications 1 à 4, dans lequel les particules polymères inertes discrètes sont constituées de triacrylate de triméthylolpropane, de méthacrylate de méthyle/tri-acrylate de triméthylolpropane, styrène/triacrylate de triméthylolpropane, méthacrylate de méthyle/di-méthacrylate de triéthylène-glycol, diacrylate de triéthylène-glycol/triacrylate de triméthylolpropane ou polyéthylène.

6. Un élément photodurcissable selon la revendication 5, dans lequel les particules polymères sont des particules d'un polymère de triacrylate de triméthylolpropane.

7. Un procédé de formation d'une image positive qui consiste (1) à exposer, selon une image, un élément photodurcissable selon la revendication 1 à un rayonnement actinique, (2) à réexposer l'élément à un rayonnement actinique de plus de 400 nm, et (3) à éliminer, par développement en milieu liquide, la couche non photosensible éliminable par un liquide et les zones non polymérisées de la ou des couches photodurcissables, les particules polymères inertes discrètes étant présentes dans les zones polymérisées de la couche photodurcissable.